Europäisches Patentamt

European Patent Office

Office européen des brevets

(11) Veröffentlichungsnummer: **0 181 504**
**A1**

## (12) EUROPÄISCHE PATENTANMELDUNG

(21) Anmeldenummer: 85112907.2

(22) Anmeldetag: 11.10.85

(51) Int. Cl.4 **G01N 24/08** , G01N 24/06

(30) Priorität: 26.10.84 DE 3439331

(43) Veröffentlichungstag der Anmeldung:
**21.05.86 Patentblatt 86/21**

(84) Benannte Vertragsstaaten:
**DE FR GB NL**

(71) Anmelder: **Siemens Aktiengesellschaft**
**Berlin und München Wittelsbacherplatz 2**
**D-8000 München 2(DE)**

(72) Erfinder: **Riedl, Hermann**
**Dechsendorfer Strasse 6**
**D-8520 Erlangen(DE)**

(54) **Kernspintomographiegerät.**

(57) Die Erfindung betrifft ein Kernspintomographiegerät zur Darstellung von Bereichen aus dem Innern eines Untersuchungsobjektes (5) mit Spulen (1 bis 8) zum Anlegen von magnetischen Grund- und Gradientenfeldern an das Untersuchungsobjekt (5) und mindestens einer Meßspule (9) zum Erfassen der Auslenkung der Kernspins des Untersuchungsobjektes aus ihrer Gleichgewichtslage. Für die Auslenkung der Richtung der Kernmagnetisierung relativ zum Grund-Magnetfeld sind Mittel (7, 8, 13, 14) zur Richtungsänderung des Grund-Magnetfeldes vorhanden.

EP 0 181 504 A1

Kernspintomographiegerät

Die Erfindung betrifft ein Kernspintomographiegerät zur Darstellung von Bereichen aus dem Innern eines Untersuchungsobjektes mit Spulen zum Anlegen von magnetischen Grund- und Gradientenfeldern an das Untersuchungsobjekt und mindestens einer Meßspule zum Erfassen der Auslenkung der Kernspins des Untersuchungsobjektes aus ihrer Gleichgewichtslage durch magnetische Anregungsimpulse.

Ein Gerät dieser Art ist in der deutschen Patentanmeldung P 3135335.5 beschrieben. Durch dieses Gerät ist es möglich, insbesondere die Kernspins eines Untersuchungsobjektes aus einer Vorzugsrichtung, die durch ein Magnet-Grundfeld erzeugt wird, durch einen hochfrequenten Anregungsimpuls auszulenken und beim Einpendeln der Kernspins nach dem Ende des Anregungsimpulses, d.h. bei der Präzession der Kernspins, ein Signal zu erzeugen, dessen Frequenz von der Stärke des Magnet-Grundfeldes abhängt. Überlagert man dem homogenen Magnet-Grundfeld einen Feldgradienten, so daß die Magnetfeldverteilung räumlich variiert, so ist eine Ortung über die jeweils gemessene Frequenz möglich. Auf diese Weise und durch Änderung der Richtung des Feldgradienten können auch Schichtbilder des Untersuchungsobjektes erzeugt werden. Die Anregung in einer Schicht des Untersuchungsobjektes erfolgt dabei dadurch, daß das Magnet-Grundfeld durch einen weiteren Feldgradienten so beeinflußt wird, daß nur in dieser Schicht eine Anregung der Kernspins erfolgt. Dies ist möglich, weil die Anregung nur mit einer Frequenz erfolgt, die dem Magnetfeld in der ge wünschten Schicht streng zugeordnet ist.

Der Erfindung liegt die Aufgabe zugrunde, ein Kernspintomographiegerät der eingangs genannten Art so auszubilden, daß die Anwendung hochfrequenter Anregungsimpulse zur Auslenkung der Kernspins nicht zwingend erforderlich ist.

Diese Aufgabe ist erfindungsgemäß dadurch gelöst, daß Mittel zur Richtungsänderung des Grund-Magnetfeldes vorhanden sind.

Bei Kernspintomographiegeräten mit statischen Grund-Magnetfeldern ist ein Meßsignal (MR-Signal) nur dann erzielbar, wenn Kernspins bzw. Kernspin-Ensembles vorhanden sind, die einen resultierenden vektoriellen Anteil senkrecht zur Richtung der Grundfeldes aufweisen. Zur Erzeugung eines vektoriellen Anteiles der Kernspins bzw. der Kernmagnetisierung senkrecht zur Richtung des Grundfeldes wird bisher in der beschriebenen Weise ein hochfrequentes Zusatz-Magnetfeld benutzt. Unabhängig vom gewählten Verfahren zur Anregung der nuklearmagnetischen Resonanz erfolgt dabei eine Auslenkung der Kernmagnetisierungsrichtung aus ihrer Ruhelage, die im eingeschwungenen Zustand parallel zur Richtung des Grundfeldes ist.

Bei dem erfindungsgemäßen Kernspintomographiegerät erfolgt nun die Auslenkung der Richtung der Kernmagnetisierung relativ zum Grund-Magnetfeld durch Richtungsänderung, insbesondere durch eine kontinuierliche Richtungsänderung des Grund-Magnetfeldes bei gleichbleibendem Betrag dieses Magnetfeldes. Nach einer Richtungsänderung des Grund-Magnetfeldes um einen Winkel von 90° in einer Zeit, die kurz gegenüber der Spin-Gitter-Relaxationszeit ist, ist die resultierende Kernmagnetisierung senkrecht zur Richtung des Grund-Magnetfeldes, so daß ein entsprechendes MR-Signal meßbar ist. Wird ein kontinuierlich rotierendes Grund-Magnetfeld angewendet, so weisen die Kernspins wegen des nun kontinuierlich ablaufenden Relaxationsprozesses eine Winkelabweichung relativ zur Grund-Magnetfeldrichtung auf.

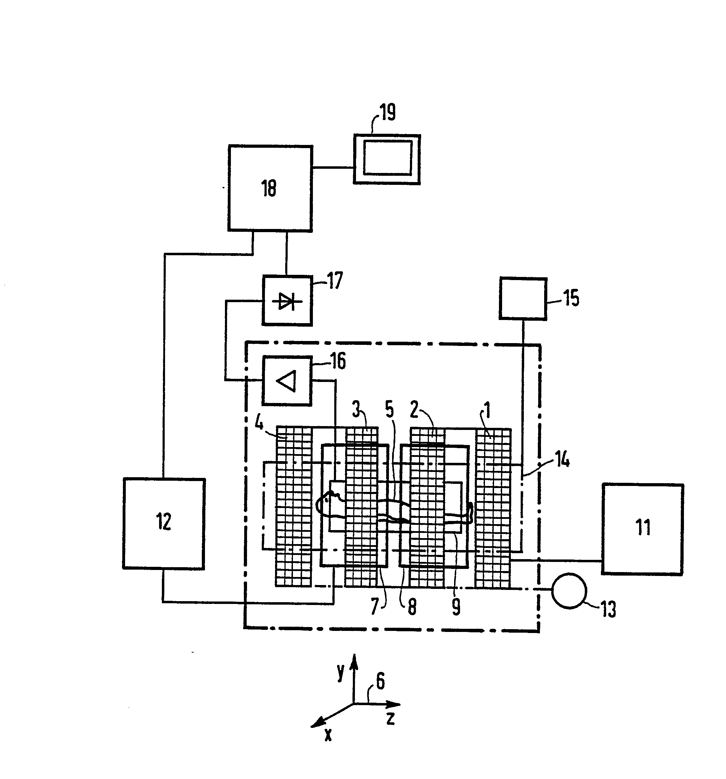

Die Erfindung ist nachfolgend anhand eines in der Zeichnung dargestellten Ausführungsbeispieles näher erläutert.

In der Figur sind mit 1 und 2 sowie 3 und 4 Spulen gekennzeichnet, mit welchen ein magnetisches Gleichfeld $B_0$erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur sind der Übersichtlichkeit halber nur Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Aufnahme der Kernresonanzsignale dienende Spule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die zur Aufnahme des Signales dienende Meßspule 9 liegt über einen Signalverstärker 16 und einen phasenempfindlichen Gleichrichter 17 an einem Prozeßrechner 18, von dem aus zur Ausgabe der Abbildung ein Bildschirmgerät 19 versorgt wird.

Bei dem Gerät gemäß der Figur ist die Meßspule 9 so ausgebildet, daß Schnittbilder des Körpers 5 dargestellt werden können.

Die Auslenkung der Richtung der Kernmagnetisierung relativ zum Grund-Magnetfeld erfolgt bei dem Ausführungsbeispiel gemäß der Figur durch Richtungsänderung, insbesondere eine kontinuierliche Richtungsänderung des Grund-Magnetfeldes, bei gleichbleibendem Betrag dieses Feldes. Hierzu dienen auch die Gradientenspulen 7, 8, die richtungsunveränderliche oder richtungsveränderliche sowie in ihrer Stärke variierbare Feldgradienten für diesen Zweck erzeugen. Die Auslenkung kann aber auch durch mechanische Drehung der Spulen 1 bis 4 mit Hilfe eines Motors 13 erfolgen. Schließlich kann ein rotierendes Grund-Magnetfeld durch ein Spulensystem 14 erzeugt werden, das von einer Speiseeinrichtung 15 mit phasenverschobenen Strömen oder zeitlich versetzten Strompulsen betrieben wird.

Bei dem beschriebenen Kernspintomographiegerät kann auf Hochfrequenz-Magnetfelder zur Auslenkung der Richtung der Kernmagnetisierung ganz verzichtet werden. Es ist jedoch auch möglich, Hochfrequenzfelder und Grundfeld-Richtungsänderungen in Kombination anzuwenden.

**Ansprüche**

1. Kernspintomographiegerät zur Darstellung von Bereichen aus dem Innern eines Untersuchungsobjektes (5) mit Spulen (1 bis 8) zum Anlegen von magnetischen Grund- und Gradientenfeldern an das Untersuchungsobjekt (5) und mindestens einer Meßspule (9) zum Erfassen der Auslenkung der Kernspins des Untersuchungsobjektes (5) aus ihrer Gleichgewichtslage, **dadurch gekennzeichnet,** daß Mittel (7, 8, 13, 14) zur Richtungsänderung des Grund-Magnetfeldes vorhanden sind.

2. Kernspintomographiegerät nach Anspruch 1, **gekennzeichnet durch** Mittel (7, 8) zur Erzeugung von Hilfsmagnetfeldern für die Bildung von richtungsunveränderlichen oder richtungsveränderlichen sowie in ihrer Stärke variierbaren Feldgradienten.

3. Kernspintomographiegerät nach Anspruch 1, **gekennzeichnet durch** Mittel (13) zur Erzeugung eines rotierenden Grund-Magnetfeldes durch mechanische Drehung der Grundfeldspulen (1 bis 4).

4. Kernspintomographiegerät nach Anspruch 1, **gekennzeichnet durch** ein Spulensystem (14), das zur Erzeugung eines rotierenden Grund-Magnetfeldes mit phasenverschobenen Strömen oder zeitlich versetzten Strompulsen betrieben wird.

5. Verfahren zum Betrieb eines Kernspintomographiegerätes nach einem der Ansprüche 1 bis 4, **dadurch gekennzeichnet,** daß zur Auslenkung der Richtung der Kernmagnetisierung Hochfrequenzfelder und Grundfeld-Richtungsänderungen in Kombination angewandt werden.

# Europäisches Patentamt

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 128 746 (UTSUNOMIYA UNIVERSITY) <br> * Seite 1, Zeile 48 - Seite 2, Zeile 34 * | 1,5 | G 01 N 24/08 <br> G 01 N 24/06 |
| A | GB-A-2 076 542 (EMI LTD.) <br> * Seite 3, Zeilen 33-89 * | 1,2 | |
| A | EP-A-0 115 642 (WISCONSIN ALUMNI RESEARCH FOUNDATION) <br> * Seite 5, Zeile 20 - Seite 6, Zeile 26; Seite 9, Zeilen 11-25 * | 1,2,5 | |
| A | EP-A-0 076 400 (SIEMENS AG) <br> * Seite 3, Zeile 18 - Seite 5, Zeile 17 * | 1,2 | |
| | ----- | | RECHERCHIERTE SACHGEBIETE (Int. Cl.4) <br><br> G 01 N 24/00 |

Der vorliegende Recherchenbericht wurde für alle Patentansprüche erstellt.

| Recherchenort DEN HAAG | Abschlußdatum der Recherche 05-02-1986 | Prüfer HORAK G.I. |
|---|---|---|